# EUROPÄISCHE PATENTSCHRIFT

(11) **EP 1 212 801 B1**
(45) Veröffentlichungstag und Bekanntmachung des Hinweises auf die Patenterteilung: **29.06.2005**
(21) Anmeldenummer: 00960344.0
(22) Anmeldetag: 10.08.2000
(51) Int. Cl.: H01L 41/083, H01L 41/22

(54) **VERFAHREN ZUR HERSTELLUNG VON PIEZOAKTOREN MIT EINEM MEHRSCHICHTAUFBAU VON PIEZOLAGEN**
METHOD FOR PRODUCING PIEZO ACTUATORS WITH A MULTIPLE-LAYER STRUCTURE OF PIEZO LAYERS
PROCEDE DE PRODUCTION D'ACTEURS PIEZO-ELECTRIQUES AVEC UNE STRUCTURE MULTICOUCHE DE COUCHES PIEZO-ELECTRIQUES

(30) Priorität: 13.08.1999 DE 19938456
(43) Veröffentlichungstag der Anmeldung: 12.06.2002
(73) Patentinhaber: ROBERT BOSCH GMBH, 70442 Stuttgart (DE)
(72) Erfinder: EISELE, Ulrich, D-70199 Stuttgart (DE)
(86) Internationale Anmeldenummer: PCT/DE2000/002669
(87) Internationale Veröffentlichungsnummer: WO 2001/013440

(56) Entgegenhaltungen:
- WO-A-99/13681
- PATENT ABSTRACTS OF JAPAN vol. 017, no. 466 (E-1421), 25. August 1993 (1993-08-25) & JP 05 110156 A (NEC CORP), 30. April 1993 (1993-04-30) -& JP 05 110156 A (NEC CORP) 30. April 1993 (1993-04-30)
- PATENT ABSTRACTS OF JAPAN vol. 017, no. 115 (E-1330), 10. März 1993 (1993-03-10) & JP 04 295286 A (FUJITSU LTD), 20. Oktober 1992 (1992-10-20) -& JP 04 295286 A (FUJITSU LTD) 20. Oktober 1992 (1992-10-20)
- PATENT ABSTRACTS OF JAPAN vol. 017, no. 356 (E-1394), 6. Juli 1993 (1993-07-06) & JP 05 055659 A (ALPS ELECTRIC CO LTD), 5. März 1993 (1993-03-05) -& JP 05 055659 A (ALPS ELECTRIC CO LTD) 5. März 1993 (1993-03-05)

## Beschreibung

### Stand der Technik

Die Erfindung betrifft ein Verfahren zur Herstellung von Piezoaktoren mit einem Mehrschichtaufbau von Piezolagen, beispielsweise für einen Piezoaktor zur Betätigung eines mechanischen Bauteils wie ein Ventil oder dergleichen, nach den gattungsgemäßen Merkmalen des Hauptanspruchs und eine Vorrichtung zur Durchführung des Verfahrens.

Es ist allgemein bekannt, Piezoaktoren mit Piezoelementen zur Ausnutzung des sogenannten Piezoeffekts herzustellen, die aus einem Material mit einer geeigneten Kristallstruktur aufgebaut werden. Der Aufbau dieses Piezoaktors erfolgt hier in mehreren Schichten (Mehrschicht-bzw. Multilayer-Piezoaktoren), wobei die Elektroden, über die die elektrische Spannung aufgebracht wird, jeweils zwischen den Schichten angeordnet werden. Diese piezoelektrischen Mehrschichtaktoren werden in herkömmlicher Weise durch Foliengießen, Aufdrucken der Elektroden und Laminieren hergestellt. Das Bedrucken, das Zwischentrocknen und das Laminieren sind hier sog. Batch-Prozesse. Die Piezoaktoren haben einige 100 Laminatschichten, wobei die Kontaktierung durch zwei an den Seiten angebrachte Elektroden erfolgt. Die Innenelektroden müssen im Wechsel im Inneren des Aktors enden, da sonst ein Kurzschluss zum jeweiligen Gegenpol entstünde. An diesen Enden entstehen im Betrieb mechanische Spannungen, die zu einer schädlichen Rissbildung führen können und das Wachsen dieser Risse begrenzt im Betrieb letztlich die Lebensdauer des Piezoaktors.

Bei Anlage einer äußeren elektrischen Spannung an die Innenelektroden erfolgt eine mechanische Reaktion des Piezoelements, die in Abhängigkeit von der Kristallstruktur und der Richtung der elektrischen Spannung einen Druck oder Zug in eine vorgebbare Richtung darstellt. Durch eine elektrische Aufladung der Piezokeramikstapel dehnen sich diese aus oder ziehen sich zusammen. Der damit verbundene Hub der Piezokeramikstapel kann zum Schalten eines Ventils eingesetzt werden, beispielsweise zur Steuerung der Kraftstoff zumessung in einem Verbrennungsmotor.

In der WO 99/13681 A ist ein spiral- oder helixförmiger Aktor offenbart. Dessen Windungen sind aus zwei miteinander verbundenen Materiallagen gebildet, wobei wenigstens eine dieser Materiallagen aus piezokeramischem Material besteht. Auf den Außenseiten dieser Materiallagen sind Elektroden angebracht. Die einzelnen Windungen sind axial beabstandet, um einen Kurzschluß zwischen den Elektroden zu vermeiden.

### Vorteile der Erfindung

Ein Verfahren zur Herstellung eines Piezoaktors mit einem Mehrschichtaufbau von Lagen aus einer Piezofolie und mit dazwischen angeordneten Innenelektroden wird in vorteilhafter Weise dadurch weitergebildet, dass die einzelnen Lagen der Piezofolie aus zwei durchgehenden Strängen, z.B. mit einem trapezförmigen Querschnitt, gebildet werden, wobei die beiden Stränge unter Einschluss der dazwischen liegenden Innenelektrode in Form einer Doppelhelix zur Bildung eines hohlzylindrischen Stapels übereinander gewickelt werden.

Mit der Erfindung kann auf einfache Weise ein Doppelhelix-Piezoaktor gebildet, bei dem aufgrund des vorteilhaften Aufbaus die eingangs beschriebene Ausfallgefahr durch eine Rissbildung stark vermindert ist. Es liegen hier zwei gegeneinander isolierte Dielektrikum-Elektrode-Paare als Doppelhelix vor. Der Piezoaktor hat die Form eines Hohlzylinders und die beiden Innenelektroden haben nur ein Ende an einer Stirnseite des Piezoaktors, wo die Außenkontaktierung erfolgt. Durch das kontinuierliche Fertigungsverfahren werden die eingangs erwähnten Batch-Prozesse und die Nachteile bei dem Betrieb des so hergestellten Piezoaktors vermieden.

Bei einer bevorzugten Ausführungsform sind die beiden Stränge derart über Umlenkrollen geführt, dass die Auflagen der beiden Stränge auf dem bereits gewickelten Stapel um einen vorgegebenen Winkelbetrag gegeneinander versetzt sind. Der vorgegebenen Winkelbetrag kann hier ca. 150° betragen.

Die Innenelektroden können auf einfache Weise dadurch zwischen die gewickelten Lagen gebracht werden, dass die beiden Stränge während der Führung über die Umlenkrollen mittels einer weiteren Rolle mit einer Elektrodenpaste versehen werden. Weiterhin können die beiden Stränge im Bereich der Auflage auf dem bereits gewickelten Stapel mit jeweils einer Anpressrolle auf den Stapel gedrückt werden.

Die beiden Stränge werden gemäß einer vorteilhaften Ausführungsform des erfindungsgemäßen Verfahrens jeweils mittels einer Extruderdüse aus einem Piezocompound extrudiert, dann um ein Leerrohr gewickelt und nach Erreichen einer vorgegebenen Länge abgetrennt. In einem Thermoverfahren kann der Stapel dann gesintert werden, wobei auch das Leerrohr entfernt wird. Für viele Anwendungsfälle, beispielsweise die piezogetriebene Ausführung einer Kraftstoff-Direkteinspritzung ist ein Piezoaktor mit einer zentraler Bohrung vorgesehen, was durch diese vorgeschlagene Bauform automatisch gegeben ist.

Ein vorteilhafte Vorrichtung zur Anwendung des zuvor beschriebenen Verfahrens weist eine Extruderdüse zur Bildung der Stränge, drei Umlenkrollen zur Führung der Stränge, zwei Anpressrollen zur Aufbringung der Stränge auf den Stapel, mindestens zwei Druckrollen zur Aufbringung der Elektrodenpaste und ein Leerrohr zur Zentrierung des hohlzylindrischen Stapels auf.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ein Ausführungsbeispiel einer Vorrichtung zur Anwendung des erfindungsgemäßen Verfahrens zur Herstellung eines Mehrschicht-Piezoaktors wird anhand der Zeichnung erläutert. Es zeigen:
Figur 1 eine Schematische Ansicht der Vorrichtung zur Herstellung eines Doppelhelix-Aufbaus der Piezolagen;
Figur 2 eine Draufsicht auf die Anordnung nach der Figur 1;
Figur 3 eine Detailansicht von Anpressrollen beim Aufwickeln der Stränge auf den Stapel und
Figur 4 eine Detailansicht des Aufdruckens der Elektrodenpaste zur Bildung der Innenelektroden auf den Strängen.

### Beschreibung des Ausführungsbeispiels

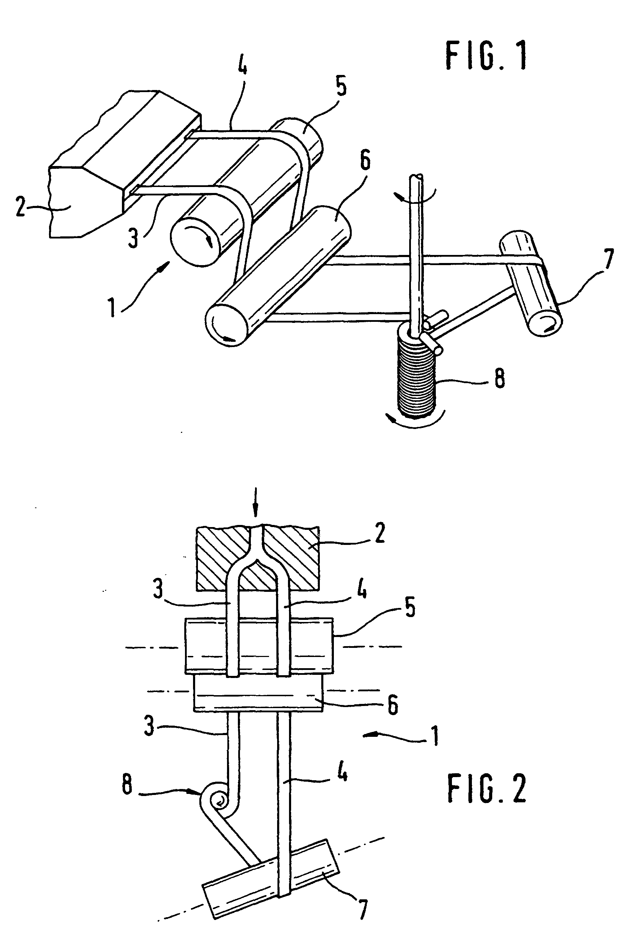

Eine Vorrichtung 1 nach Figur 1 enthält eine Extrudereinrichtung 2, mit der zwei parallele Stränge 3 und 4 eines speziellen Piezocompounds aus entsprechenden Düsen extrudiert werden. Beide Stränge 3 und 4 haben einen trapezförmigen Querschnitt, um die größere Verformung der Außenseite bei der Wicklung auszugleichen. Die Stränge 3 und 4 werden parallel über eine erste Umlenkrolle 5 und eine zweite Umlenkrolle 6 geführt. Eine dritte Umlenkrolle 7 führt einen der Stränge 4 derart umgelenkt in Gegenrichtung und um ca. 30° ausgelenkt zurück, dass die beiden Stränge 3 und 4 dann um ca. 150° versetzt auf die bereits fertigen Wicklungen des Stapels des Piezoaktors 8 gewickelt werden.

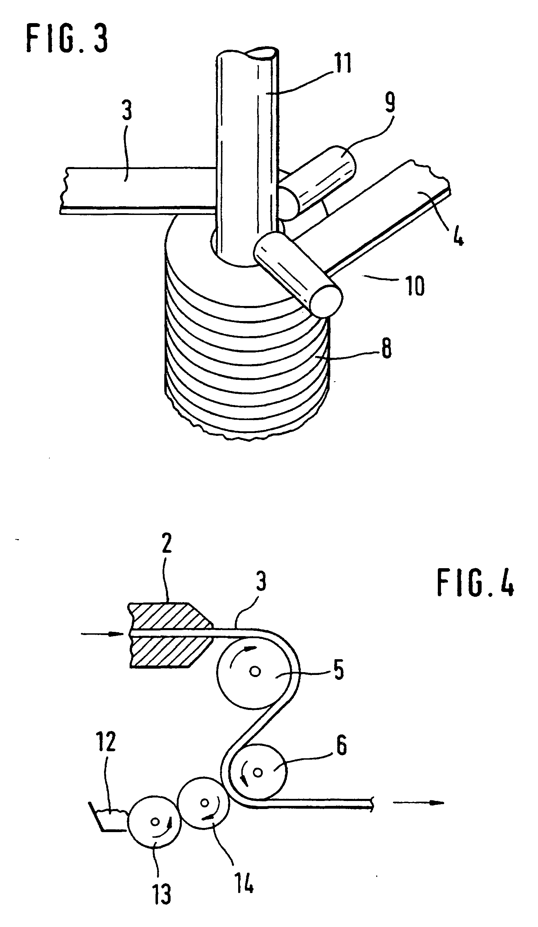

Aus Figur 2 ist die Vorrichtung 1 nach der Figur 1 noch einmal in einer Draufsicht zu entnehmen. Figur 3 zeigt die Bildung des Stapels des Piezoaktors 8 im Detail, wobei hier insbesondere jeweils eine Anpressrolle 9 für den Strang 3 und eine Anpressrolle 10 deutlich zu erkennen ist. Die Anpressrollen 9 und 10 drücken die Stränge 3 und 4 jeweils auf die untere Wicklung und sorgen so für eine gute Verbindung der Lagen des Stapels des Piezoaktors 8. Ein Leerrohr 11 aus Kunststoff, das von oben zugeführt werden kann, sorgt hier für die gute Zentrierung des Stapels des Piezoaktors 8.

Figur 4 zeigt eine Möglichkeit der Aufbringung einer Elektrodenpaste 12 auf die Stränge 3 und 4. Die Aufbringung erfolgt hier über Rollen 13 und 14 auf die eine Seite der Stränge 3 und 4 durch Aufrollen der Paste 12 während der Herstellung der Wicklung. Es entsteht somit während der Herstellung ein unendlich langer Grundkörper des Piezoaktors 8, der auf ein für den jeweiligen Anwendungsfall gefordertes Maß abgeschnitten werden kann. Durch eine thermische Behandlung des gewickelten Stapels des Piezoaktors 8 werden die Prozesshilfsmittel (Binder, etc.) aus dem Compound und der Elektrodenpaste entfernt und auch das Leerrohr 11 zersetzt. Danach wird der Grundkörper des Piezoaktors 8 gesintert.

## Patentansprüche

1. Verfahren zur Herstellung eines Piezoaktors (8) mit einem Mehrschichtaufbau von Lagen aus einer Piezofolie (3,4) und mit dazwischen angeordneten Innenelektroden, **dadurch gekennzeichnet, dass**
- die einzelnen Lagen aus zwei durchgehenden Strängen (3,4) der Piezofolie gebildet werden, wobei die beiden Stränge (3,4) unter Einschluss der dazwischenliegenden Innenelektrode in Form einer Doppelhelix zur Bildung eines hohlzylindrischen Stapels übereinander gewickelt werden.

2. Verfahren nach Anspruch 1, **dadurch gekennzeichnet, dass**
- die beiden Stränge (3,5) derart über Umlenkrollen (5,6,7) geführt werden, dass die Auflagen der beiden Stränge (3,4) auf dem bereits gewickelten Stapel um einen vorgegebenen Winkelbetrag gegeneinander versetzt sind.

3. Verfahren nach Anspruch 2, **dadurch gekennzeichnet, dass**
- der vorgegebenen Winkelbetrag ca. 150° beträgt.

4. Verfahren nach einem der vorhergehenden Ansprüche, **dadurch gekennzeichnet, dass**
- die beiden Stränge (3,4) während der Führung über die Umlenkrollen (5,6) mittels mindestens einer weiteren Rolle (13,14) mit einer Elektrodenpaste (12) versehen werden.

5. Verfahren nach einem der vorhergehenden Ansprüche, **dadurch gekennzeichnet, dass**
- die beiden Stränge (3,4) im Bereich der Auflage auf dem bereits gewickelten Stapel mit jeweils einer Anpressrolle (9,10) auf den Stapel gedrückt werden.

6. Verfahren nach einem der vorhergehenden Ansprüche, **dadurch gekennzeichnet, dass**
- die Stränge (3,4) eine trapezförmigen Querschnitt aufweisen.

7. Verfahren nach einem der vorhergehenden Ansprüche, **dadurch gekennzeichnet, dass**
- die beiden Stränge (3,4) jeweils mittels einer Extruderdüse (2) aus einem Piezocompound extrudiert werden, dann um ein Leerrohr (11) gewickelt und nach Erreichen einer vorgegebenen Länge abgetrennt werden und dass
- in einem Thermoverfahren der Stapel entbindet und das Leerrohr (11) durch Zersetzung oder ähnliche Verfahren entfernt wird.

8. Vorrichtung zur Anwendung des Verfahrens nach einem der vorhergehenden Ansprüche, **dadurch gekennzeichnet, dass**
- eine Extruderdüse (2) zur Bildung der Stränge (3,4),drei Umlenkrollen (5,6,7) zur Führung der Stränge (3,4),zwei Anpressrollen (9,10) zur Aufbringung der Stränge (3,4) auf den Stapel,
- mindestens eine Druckrolle (13,14) zur Aufbringung einer Elektrodenpaste (12) und ein Leerrohr (119 zur Zentrierung des hohlzylindrischen Stapels vorhanden ist.

## Claims

1. Method for producing a piezo actuator (8) with a multiple-layer structure of layers of a piezo foil (3, 4) and with internal electrodes arranged in between, **characterized in that**
- the individual layers are formed by two continuous strands (3, 4) of the piezo foil, the two strands (3, 4) being wound one on top of the other, including the intermediate internal electrode, in the form of a double helix to form a hollow-cylindrical stack.

2. Method according to Claim 1, **characterized in that**
- the two strands (3, 5) are guided over deflection rollers (5, 6, 7) in such a way that the supporting surfaces of the two strands (3, 4) are offset from each other by a predetermined angular amount on the already wound stack.

3. Method according to Claim 2, **characterized in that**
- the predetermined angular amount is about 150°.

4. Method according to one of the preceding claims, **characterized in that**
- during the guidance over the deflection rollers (5, 6), the two strands (3, 4) are provided with an electrode paste (12) by means of at least one further roller (13, 14).

5. Method according to one of the preceding claims, **characterized in that**
- the two strands (3, 4) are pressed onto the stack in the region of the supporting surface on the already wound stack within each case a pressing roller (9, 10).

6. Method according to one of the preceding claims, **characterized in that**
- the strands (3, 4) have a trapezoidal cross-section.

7. Method according to one of the preceding claims, **characterized in that**
- the two strands (3, 4) are respectively extruded from a piezo compound by means of an extruder die (2), then wound round an empty tube (11) and, after reaching a predetermined length, are cut off, and **in that**
- in a thermal process the binder is removed from the stack and the empty tube (11) is removed by decomposition or similar processes.

8. Apparatus for applying the method according to one of the preceding claims, **characterized in that** there are
- an extruder die (2) for forming the strands (3, 4), three deflection rollers (5, 6, 7) for guiding the strands (3, 4), two pressing rollers (9, 10) for applying the strands (3, 4) to the stack,
- at least one pressure roller (13, 14) for applying an electrode paste (12) and an empty tube (119) for centring the hollow-cylindrical stack.

## Revendications

1. Procédé de production d'un actionneur piézoélectrique (8) ayant plusieurs épaisseurs de couches constituées d'une feuille piézoélectrique (3, 4), et avec entre elles des électrodes intérieures,
**caractérisé en ce que**
les couches particulières sont formées à partir de deux cordons (3, 4) continus de la feuille piézoélectrique,
les deux cordons (3, 4) étant enroulés l'un sur l'autre pour former une pile cylindrique sous forme d'une double hélice creuse en incluant l'électrode intérieure placée entre eux.

2. Procédé selon la revendication 1,
**caractérisé en ce que**
les deux cordons (3. 4) sont guidés par des rouleaux de renvoi (5, 6, 7) de telle manière que les deux cordons (3, 4) se posent sur les piles déjà enroulées en étant décalés l'un par rapport à l'autre d'une valeur angulaire prédéfinie.

3. Procédé selon la revendication 2,
**caractérisé en ce que**
la valeur angulaire prédéfinie est d'environ 150°.

4. Procédé selon l'une des revendications précédentes,
**caractérisé en ce que**
pendant qu'ils sont guidés sur les rouleaux de renvoi (5, 6), les deux cordons (3, 4) sont munis d'une pâte à électrodes (12) à l'aide d'au moins un autre rouleau (13, 14).

5. Procédé selon l'une des revendications précédentes,
**caractérisé en ce que**
dans la zone où ils sont posés sur la pile déjà enroulée, chacun des deux cordons (3, 4) est pressé sur la pile à l'aide d'un rouleau de pressage (9, 10).

6. Procédé selon l'une des revendications précédentes,
**caractérisé en ce que**
les cordons (3, 4) ont une section transversale trapézoïdale.

7. Procédé selon l'une des revendications précédentes,
**caractérisé en ce que**
chacun des deux cordons (3, 4) est extrudé à partir d'un composé piézoélectrique à l'aide d'une buse d'extrusion (2) puis est enroulé autour d'un tube vide (11) et est sectionné après avoir atteint une longueur prédéfinie, et
la pile se détache d'après un procédé thermique et le tube vide (11) est retiré en le désagrégeant ou en utilisant un autre procédé.

8. Dispositif pour appliquer le procédé selon l'une des revendications précédentes,
**caractérisé en ce qu'**
il comporte une buse d'extrusion (2) pour former les cordons (3, 4), trois rouleaux de déviation (5, 6, 7) pour guider les cordons (3, 4), deux rouleaux de pressage (9, 10) pour appliquer les cordons (3, 4) sur la pile, au moins un rouleau presseur (13, 14) pour appliquer une pâte à électrodes (12) et un tube vide (11) pour centrer la pile cylindrique creuse.
